Europäisches Patentamt

European Patent Office

Office européen des brevets

(19)

(11) **EP 0 856 160 B1**

(12) **EUROPÄISCHE PATENTSCHRIFT**

(45) Veröffentlichungstag und Bekanntmachung des Hinweises auf die Patenterteilung:
**13.10.1999 Patentblatt 1999/41**

(21) Anmeldenummer: **96924739.4**

(22) Anmeldetag: **17.07.1996**

(51) Int Cl.⁶: **G01R 27/02**, B60R 21/00

(86) Internationale Anmeldenummer:
**PCT/DE96/01297**

(87) Internationale Veröffentlichungsnummer:
**WO 97/15834 (01.05.1997 Gazette 1997/19)**

(54) **ANORDNUNG ZUM KONTROLLIEREN EINER AN EINEM ÜBERTRAGER SEKUNDÄRSEITIG ANGESCHLOSSENEN LAST**

ARRANGEMENT FOR CONTROLLING A LOAD CONNECTED TO THE SECONDARY SIDE OF A TRANSFORMER

DISPOSITIF POUR LE CONTROLE D'UNE CHARGE CONNECTEE AU COTE SECONDAIRE D'UN TRANSFORMATEUR

(84) Benannte Vertragsstaaten:
**DE FR GB IT SE**

(30) Priorität: **20.10.1995 DE 19539064**

(43) Veröffentlichungstag der Anmeldung:
**05.08.1998 Patentblatt 1998/32**

(73) Patentinhaber: **ROBERT BOSCH GMBH**
**70442 Stuttgart (DE)**

(72) Erfinder:
• **ZABLER, Erich**
**D-76297 Stutensee (DE)**
• **DUKART, Anton**
**D-76744 Wörth (DE)**

(56) Entgegenhaltungen:
**DE-C- 3 812 631        FR-A- 2 576 109**

**Beschreibung**

Stand der Technik

Die vorliegende Erfindung betrifft eine Anordnung zum Kontrollieren einer an einem Übertrager sekundärseitig angeschlossenen Last - vorzugsweise der Zündpille eines Airbag - anhand der primärseitigen Eingangsspannung des Übertragers.

Eine derartige Anordnung ist aus der DE A 38 12 633 oder aus der DE-C-38 12 631 bekannt. Gemäß diesem Stand der Technik wird beispielsweise zur Signalübertragung zwischen einem Steuergerät und einem in einem Lenkrad eines Fahrzeugs eingebauten Airbag ein Drehübertrager verwendet. Die Funktionsfähigkeit eines Airbag ist ständig zu überprüfen, damit er in jeder Notfallsituation sofort einsatzbereit ist. Dazu wird der Widerstand der Zündpille, der typischerweise im Bereich von 1,8 Ohm bis 2,5 Ohm liegen soll, einer ständig wiederkehrenden Messung unterzogen. Die Übertragung von Signalen mittels der induktiv gekoppelten Wicklungen des Drehübertragers ist vom Abstand der beiden Wicklungen, das heißt der Größe des Luftspalts zwischen den Schalenkernen der Wicklungen, abhängig. Einbau- und Fertigungstoleranzen des Lenkrades, an dem der sekundärseitige Schalenkern des Drehübertragers installiert ist, können ebenso wie die Betriebstemperatur zu einer Verfälschung des gemessenen Widerstandswertes der Zündpille führen. Um solche Meßsignalverfälschungen zu vermeiden, sieht der genannte Stand der Technik einen Schwingkreis auf der Sekundärseite des Drehübertragers vor, der von der Primärseite aus von einem Steuersignal angeregt wird. Nach Abschalten des Steuersignals wird das Abklingen des Antwortsignals des Schwingkreises auf die Primärseite zurück übertragen und aus der Zeitkonstanten des abklingenden Antwortsignals der sekundärseitige Widerstand ermittelt.

Der Anmeldung liegt die Aufgabe zugrunde, eine Anordnung der eingangs genannten Art anzugeben, die es ermöglicht, aus der primärseitigen Eingangsspannung des Übertragers eine zuverlässige Aussage über den Zustand (Widerstand) der sekundärseitig angeschlossenen Last zu gewinnen.

Vorteile der Erfindung

Gemäß den Merkmalen des Patentanspruchs wird die genannte Aufgabe dadurch gelöst, daß an der Primärseite des Übertragers ein Synchrongleichrichter angeschlossen ist, an dem die primärseitige Eingangsspannung des Übertragers und eine Steuerspannung mit derselben Frequenz wie die der Eingangsspannung anliegen, und daß die Phase der Steuerspannung zwischen 0° und 90° umschaltbar ist, so daß die Ausgangsspannung des Synchrongleichrichters bei der Phase 0° ausschließlich dem am ohmschen Eingangswiderstand des Übertragers abfallenden Spannungsanteil und bei der Phase 90° ausschließlich dem am induktiven Eingangswiderstand des Übertragers abfallenden Spannungsanteil entspricht. Da der ohmsche und der induktive Eingangswiderstand unterschiedliche Abhängigkeiten vom Widerstand der sekundärseitig angeschlossenen Last zeigen, ist es mit der erfindungsgemäßen Anordnung möglich, jeweils denjenigen Spannungsanteil auszuwerten, der eine zuverlässigere Aussage über den Zustand der sekundärseitig angeschlossenen Last liefert. Oder man gewinnt eine Information über die sekundärseitig angeschlossene Last durch einen Vergleich beider Spannungsanteile.

Anhand eines in der Zeichnung dargestellten Ausführungsbeispiels wird nachfolgend die Erfindung näher erläutert. Es zeigen:

Figur 1 eine Schaltung, mit der alternativ der ohmsche oder induktive Spannungsanteil auf der Primärseite eines Übertragers ermittelt werden kann,
Figur 2 ein Ersatzschaltbild für einen mit einer Last abgeschlossenen Übertrager und
Figur 3 die qualitative Abhängigkeit des primärseitigen ohmschen Widerstandes und der primärseitigen Induktivität des Übertragers von dem sekundärseitig angeschlossenen Lastwiderstand.

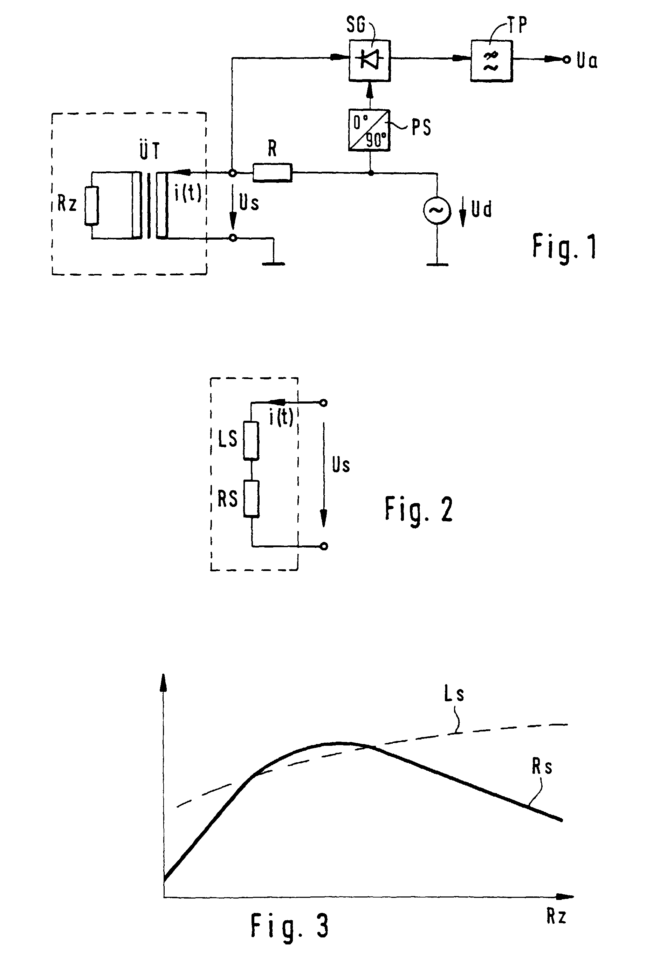

Wie einleitend dargelegt, soll von der Primärseite eines Übertragers her ein an dessen Sekundärseite angeschlossener Lastwiderstand auf Änderung hin kontrolliert werden. In der Figur 1 ist das Prinzipschaltbild eines Übertragers ÜT und eines daran sekundärseitig angeschlossenen Lastwiderstandes $R_z$ dargestellt. Der Übertrager ÜT sei beispielsweise ein Drehübertrager, der zwischen einem mit einem Airbag ausgestatteten Lenkrad und der feststehenden Lenksäule angeordnet ist. Die sekundärseitig angeschlossene Last $R_z$ entspricht dann dem Widerstand einer Zündpille des Airbag. Eine solche Zündpille hat im Normalfall einen Widerstand $R_z$ von ca.2 Ohm. Ändert sich der Widerstand der Zündpille über gewisse Grenzwerte hinaus, so deutet das darauf hin, daß die Funktion des Airbag gestört ist. Eine solche Situation muß im Fahrzeug signalisiert werden. Der Übertrager ÜT mit dem sekundärseitig angeschlossenen Lastwiderstand $R_z$ hat, von seiner Primärseite her gesehen, das in Figur 2 dargestellte Ersatzschaltbild, bestehend aus der Serienschaltung eines Widerstandes RS und einer Induktivität LS. Sowohl der Widerstand RS als auch die Induktivität LS sind abhängig von der Größe des an der Sekundärseite des Übertragers ÜT angeschlossenen Lastwiderstandes $R_z$. Diese Abhängigkeiten sind in der Figur 3 prinzipiell dargestellt. Es zeigt sich, daß der primärseitige induktive Eingangswiderstand $\omega LS$ des Übertragers eine schwächere Abhängigkeit von dem Lastwiderstand $R_z$ aufweist als der ohmsche Eingangswiderstand RS. Dagegen ist die Abhängigkeit des ohmschen Eingangswiderstandes RS vom Lastwiderstand $R_z$ nicht in allen Bereichen eindeutig im Gegensatz zum induktiven Ein-

gangswiderstand $\omega LS$ des Übertragers.

Die in Figur 1 dargestellte Schaltungsanordnung ermöglicht es nun, aus der primärseitigen Eingangsspannung Us des Übertragers ÜT eine Ausgangsspannung Ua abzuleiten, welche alternativ entweder dem induktiven Eingangswiderstand LS oder dem ohmschen Eingangswiderstand RS des Übertragers ÜT proportional ist. Anstelle von Spannungen können natürlich auch Ströme ausgewertet weden.

Am primärseitigen Eingang des Übertragers ÜT liegt eine sinusförmige Wechselspannung Ud mit der Frequenz $f_0$ (50...100 kHz) an. Durch einen Vorwiderstand R, der erheblich größer ist als die Eingangsimpedanz des Übertragers ÜT, wird auf der Primärseite des Übertragers ein Strom

$$i(t) = \hat{\imath} \sin \omega_0 t \qquad (1)$$

eingeprägt. Mit dem Strom aus Gleichung (1) läßt sich die Eingangsspannung Us des Übertragers wie folgt beschreiben:

$$Us = RS\,\hat{\imath}\,\sin\omega_0 t + \omega_0 LS\,\hat{\imath}\,\sin(\omega_0 t + 90°) \qquad (2)$$

Diese Eingangsspannung Us wird über einen Synchrongleichrichter SG abgegriffen. Dem Synchrongleichrichter SG ist als Steuerspannung die Wechselspannung Ud zugeführt. Da sowohl die Steuerspannung als auch die Eingangsspannung Us dieselbe Frequenz haben, wird am Ausgang des Synchrongleichrichters SG die gleichgerichtete Eingangsspannung Us zur Vefügung stehen. Von einer detaillierten Beschreibung der Funktion eines Synchrongleichrichters wird hier abgesehen, da es sich hierbei um eine bekannte Schaltung handelt. In U. Tietze, Ch. Schenk, "Halbleiter-Schaltungstechnik", 10. Auflage, 1993, Springer-Verlag, Seite 880 bis 885 ist ein Synchrongleichrichter beschrieben, insbesondere auch in seiner Funktion als phasenempfindlicher Gleichrichter. Ein solcher phasenempfinglicher Gleichrichter richtet nur eine solche Eingangsspannung gleich, deren Phase mit der Phase der Steuerspannung übereinstimmt. Diese Eigenschaft wird bei der vorliegenden Schaltungsanordnung ausgenutzt. Die Wechselspannung Ud gelangt über einen Phasenschalter PS, der zwischen den Phasenzuständen 0° und 90° umschaltbar ist, an den Steuereingang des Synchrongleichrichters SG. Wie der Gleichung (2) zu entnehmen ist, setzt sich die Eingangsspannung Us aus einem an dem ohmschen Eingangswiderstand RS abfallenden Spannungsanteil und einem an dem induktiven Eingangswiderstand $\omega_0 LS$ abfallenden Spannungsanteil zusammen. Befindet sich der Phasenschieber PS nun in dem Phasenzustand 0°, so ist die Steuerspannung des Synchrongleichrichters SG phasensynchron mit dem Spannungsanteil der Eingangsspannung Us, der an dem ohmschen Eingangswiderstand Rs abfällt. Die Ausgangsspannung Ua ist dann rein vom ohmschen Eingangswiderstand RS abhängig:

$$Ua \sim \hat{\imath}\,RS \qquad (3)$$

Schaltet der Phasenschalter PS auf die Phase 90° um, besteht Phasensynchronität zwischen der Steuerspannung und dem am induktiven Eingangswiderstand LS abfallenden Spannungsanteil der Eingangsspannung Us. In diesem Fall ist die Ausgangsspannung Ua des Synchrongleichrichters SG proportional zum induktiven Eingangswiderstand $\omega_0 LS$:

$$Ua \sim \hat{\imath}\,\omega_0 LS \qquad (4)$$

Ein dem Synchrongleichrichter SG nachgeschalteter Tiefpaß TP filtert aus dem Ausgangssignal des Synchrongleichrichters SG unerwünschte Wechselspannungsanteile heraus.

Mit der zuvor beschriebenen Schaltung lassen sich also zwei verschiedene Ausgangssignale Ua gewinnen, die eine unterschiedliche Abhängigkeit von dem sekundärseitig angeschlossenen Lastwiderstand Rz zeigen. Ein hier nicht näher beschriebenes Steuergerät für den Airbag kann durch Umschalten des Phasenschalters PS jeweils auf dasjenige Ausgangssignal Ua umschalten, welches die zuverlässigere Information über den Lastwiderstand (Zündpille) liefert. So hat das Ausgangssignal Ua, welches proportional zum ohmschen Eingangswiderstand RS des Übertragers ÜT ist, den Vorteil, daß es eine größere Meßempfindlichkeit für den Lastwiderstand aufweist und es deutlich zu erkennen gibt, wenn die Sekundärseite des Übertragers fehlt, z. B. wenn das Lenkrad mit dem Airbag aus dem Fahrzeug ausgebaut ist. Das Ausgangssignal Ua, welches ausschließlich proportional zu dem induktiven Eingangswiderstand $\omega_0 LS$ des Übertragers ÜT ist, gibt das Fehlen des Sekundärkreises des Übertragers nicht deutlich zu erkennen und hat auch den Nachteil einer geringen Meßempfindlichkeit für den Lastwiderstand Rz. Es hat allerdings den Vorteil, daß es eindeutig mit dem Lastwiderstand Rz verknüpft ist. Durch Auswertung beider Zustände des Ausgangssignals Ua kann auf jeden Fall eine sehr zuverlässige und genaue Aussage über den Zustand des Lastwiderstandes Rz getroffen werden.

**Patentansprüche**

1. Anordnung zum Kontrollieren einer an einem Übertrager (ÜT) sekundärseitig angeschlossenen Last -vorzugsweise der Zündpille eines Airbag - anhand der primärseitigen Eingangsspannung (Us) des Übertragers, dadurch gekennzeichnet, daß an der Primärseite des Übertragers (ÜT) ein Synchrongleichrichter (SG) angeschlossen ist, an dem die primärseitige Eingangsspannung (Us) des Übertragers (ÜT) und eine Steuerspannung mit derselben Frequenz wie die der Eingangsspannung (Us) anliegen, und daß die Phase der Steuerspannung zwischen 0° und 90° umschaltbar ist, so daß die Ausgangsspannung des Synchrongleichrichters (SG) bei der Phase 0° ausschließlich dem am ohmschen Eingangswiderstand (RS) des Übertragers (ÜT) abfallenden Spannungsanteil und bei der Phase 90° ausschließlich dem am induktiven Eingangswiderstand (LS) des Übertragers (ÜT) abfallenden Spannungsanteil entspricht, wobei sowohl der ohmsche als auch der induktive Eingangswiderstand vom Widerstand (Rz) der sekundärseitig angeschlossenen Last abhängig sind.

## Claims

1. Arrangement for monitoring a load - preferably the firing pellet of an airbag - connected to the secondary side of a transformer (ÜT) using the primary-side input voltage (Us) of the transformer, characterized in that a synchronous rectifier (SG) is connected to the primary side of the transformer (ÜT), the primary-side input voltage (Us) of the transformer (ÜT) and a control voltage having the same frequency as that of the input voltage (Us) being applied to the said synchronous rectifier, and in that the phase of the control voltage can be changed over between 0° and 90°, with the result that the output voltage of the synchronous rectifier (SG) corresponds, in the case of the phase 0°, exclusively to the voltage component dropped across the non-reactive input resistance (RS) of the transformer (ÜT) and, in the case of the phase 90°, exclusively to the voltage component dropped across the inductive input reactance (LS) of the transformer (ÜT), both the non-reactive input resistance and the inductive input reactance being dependent on the resistance (Rz) of the load connected to the secondary side.

## Revendications

1. Dispositif de contrôle d'une charge reliée au secondaire d'un transformateur (UT) (de préférence la pastille d'allumage d'une poche d'air) à l'aide de la tension d'entrée (Us) du primaire du transformateur, caractérisé en ce qu'
   un redresseur synchrone (SG) est relié au primaire du transformateur (UT), qui reçoit la tension d'entrée de primaire (Us) du transformateur (UT) et une tension de commande à la même fréquence que la tension d'entrée (Us) et la phase de la tension de commande commute entre 0° et 90° de sorte que la tension de sortie du redresseur synchrone (SG) pour la phase 0° correspond exclusivement à la composante de tension sur la résistance d'entrée ohmique (Rs) du transformateur (UT) et que pour une phase de 90°, correspond uniquement à la composante de tension de la résistance d'entrée inductive (LS) du transformateur (UT), et à la fois la résistance ohmique et la résistance inductive dépendent de la résistance (Rz) de la charge reliée au secondaire.

Fig. 1

Fig. 2

Fig. 3